# EUROPÄISCHE PATENTANMELDUNG

(11) **EP 1 065 787 A2**
(43) Veröffentlichungstag der Anmeldung: **03.01.2001**
(21) Anmeldenummer: 00112902.2
(22) Anmeldetag: 19.06.2000
(51) Int. Cl.: H03K 23/00

(54) **Hochgeschwindigkeitszähler**

(30) Priorität: 30.06.1999 DE 19930179
(71) Anmelder: Infineon Technologies AG, 81541 München (DE)
(72) Erfinder: Hölzle, Josef, 86825 Bad Wörishofen (DE)
(74) Vertreter: Zedlitz, Peter, Dipl.-Inf.

(57) **Zusammenfassung**

Die Erfindung betrifft ein Verfahren, sowie eine Schaltungsanordnung zum Hochgeschwindigkeitszählen von Taktzyklen eines Taktes, der in einem ersten Schritt in einem Verhältnis 1 zu n geteilt wird, dessen Zyklen von einer Zähleinheit (7) gezählt werden, wobei diese Zähleinheit (7) pro Taktzyklus n Schritte zählt, die Taktzyklen des geteilten Taktes hinsichtlich eines Wertes 0 bis n-1 analysiert werden und bei einem Auftreten eines Wertes 0 bis n-1 in dessen Abhängigkeit eine Verzögerung eines Signals erzeugt und ausgegeben wird.

## Beschreibung

Die Erfindung betrifft ein Verfahren zum Hochgeschwindigkeitszählen von Taktzyklen eines Taktes sowie eine Schaltungsanordnung hierfür. Derartige Verfahren und Schaltungsanordnungen werden beispielsweise in der Nachrichtentechnik, in der Hochfrequenztechnik, insbesondere zur Steuerung von Automaten wie Prüfautomaten, eingesetzt.

Um ein ordnungsgemäßes und fehlerfreies Zählen zu gewährleisten, muss die Gesamtreaktionszeit der Zählvorrichtung kleiner sein als der Mindestabstand zweier Taktzyklen eines zu zählenden Taktes. Bei den heutzutage immer höherfrequenteren Takten wird diese Forderung von herkömmlichen Zählern, wie beispielsweise Binärzählern, nicht ohne weiteres erfüllt.

Es wurde deshalb versucht, die Gesamtreaktionszeit der Zählvorrichtung, die sich aus den Summen der Reaktionszeiten der einzelnen Bauelemente eines Zählers, der Leitungslaufzeiten und der Vorbereitungszeiten der Speicherelemente zusammensetzt, zu verringern. Hauptsächlich werden für hochfrequente Anwendungen sogenannte pn-Zähler (pseudo-noise-Zähler) eingesetzt, deren Zähllogik aus wenigen EXOR-Gattern zur Rückkopplung, einer Logik zum Restart und Multiplexern zum Laden externer Daten bestehen.

Aber selbst diese schnellen Zählvorrichtungen reichen bei den immer höherfrequenter werdenden Takten oft nicht mehr aus, so dass die Gesamtreaktionszeit der Zählvorrichtung nicht mehr unter dem Mindestabstand zweier Taktzyklen liegt und die Taktzyklen demzufolge nicht mehr fehlerfrei gezählt werden können.

Der Erfindung liegt deshalb die Aufgabe zugrunde, ein Verfahren zum Hochgeschwindigkeitszählen von Taktzyklen eines Taktes sowie eine Schaltungsanordnung zur Durchführung des Verfahrens zu schaffen, welche auch bei hochfrequenten Takten ein einwandfreies und fehlerfreies Zählen der Taktzyklen gewährleistet.

Die Aufgabe wird erfindungsgemäß durch ein Verfahren sowie eine Schaltungsanordnung mit den Merkmalen der Ansprüche 1 und 6 gelöst.

Hierbei wird der hochfrequente Takt in einem ersten Schritt in einem Verhältnis 1 zu n geteilt, so dass sich dessen Frequenz um das n-fache verringert. Dieser geteilte Takt mit geringerer Frequenz wird von einer Zähleinheit gezählt, wobei die Schrittweite der Zähleinheit gleich n ist.

Als Zähleinheit können hierbei übliche Dualzähler wie beispielsweise Binärzähler, pn-Zähler usw. verwendet werden, da der geteilte Takt einen n-fachen Mindestabstand zwischen zwei Taktzyklen aufweist und die Gesamtreaktionszeit dieser Zählereinheit bzw. deren Grenzfrequenz nur unterhalb dieser Grenze liegen muss.

Selbstverständlich muss der vorgeschaltete Teiler ein einwandfreies Teilen des Taktes gewährleisten, wobei dieses durch schnelle Bauelemente, wie beispielsweise ein T-Flip-Flop (Toggle-Flip-Flop), gewährleistet werden kann. Der Takt kann so beipielsweise in einem Verhältnis 1 zu 2, also auf seine halbe Frequenz, geteilt werden, wobei aber auch andere gerad- bzw. ungeradzahlige Teilungsverhältnisse denkbar sind.

Die Zähleinheit, die wie ein herkömmlicher Zähler aufgebaut sein kann, zählt die Zyklen des um den Faktor n geteilten Taktes, wobei die Schrittweite der Zähleinheit ebenfalls n beträgt.

Ein halbierter Takt, also ein Takt mit halber Frequenz, kann deshalb von einem üblichen Binärzähler, dessen Gesamtreaktionszeit hierfür ausreicht, also kleiner als der zweifache Mindestabstand zweier Zyklen ist, mit der Schrittweite 2 abwärts oder aufwärts gezählt werden.

Über geeignete kombinatorische Bauelemente, beispielsweise Multiplexer, kann die Schaltung mit vordefinierten Werten geladen werden, so dass vorteihafterweise ein Auf- oder Abwärtszählen von einem ersten bis zu einem zweiten vordefinierten geladenen Wert ermöglicht wird. Die Werte müssen hierbei nicht notwendigerweise geladen werden, sondern können auch durch eine geeignete Kombinatorik fest eingestellt sein.

In einer Ausführungsform der Erfindung kann ein Abwärtszähler so von einem vordefinierten geladenen Wert x bis zu einem zweiten vordefinierten Wert y, beispielsweise 0, abwärts zählen.

Um den zweiten vordefinierten Wert, der sich bei einer n-fachen Teilung des Taktes innerhalb eines Taktzyklus an erster bis n-ter Stelle befinden kann, ordnungsgemäß zu zählen, wird jeweils der mögliche Zustand 0 bis n-1 eines Taktzyklus bzw. dessen Anfangszustand analysiert und in Abhängigkeit von diesem Wert (0 bis n-1) des Anfangszustandes am Ausgang eine entsprechende Verzögerung des Impulses, beispielsweise 1 bis n Taktzyklen, erzeugt. Hierbei kann der ausgegebene Impuls für den Zahlenwert "0" vorteilhafterweise dieselbe Impulsbreite wie der dekodierte Impuls des geteilten Taktes aufweisen.

Durch die n-fache Teilung des Taktes muss die Gesamtreaktionszeit der Zähleinheit nur noch unter dem n-fachen Mindestabstand zweier Taktzyklen liegen, um ein ordnungsgemäßes Zählen zu gewährleisten.

Auf diese Weise können auch die Taktzyklen eines hochfrequenten Taktes fehlerfrei gezählt werden, wobei durch das besondere Verfahren und die Schaltungsanordnung zur Durchführung des Verfahrens vorteilhafterweise auf herkömmliche günstige Bauelemente zurückgegriffen werden kann.

Weitere vorteilhafte Ausgestaltungen der Erfindung ergeben sich aus den Unteransprüchen.

Die Erfindung wird nachfolgend anhand eines in der Zeichnung dargestellten Ausführungsbeispiels erläutert. In der Zeichnung zeigen:
- Fig. 1: eine schematische Darstellung einer Schaltungsanordnung nach der Erfindung, und
- Fig. 2a bis 2i: Signalverläufe der Schaltungsanordnung nach Fig. 1.

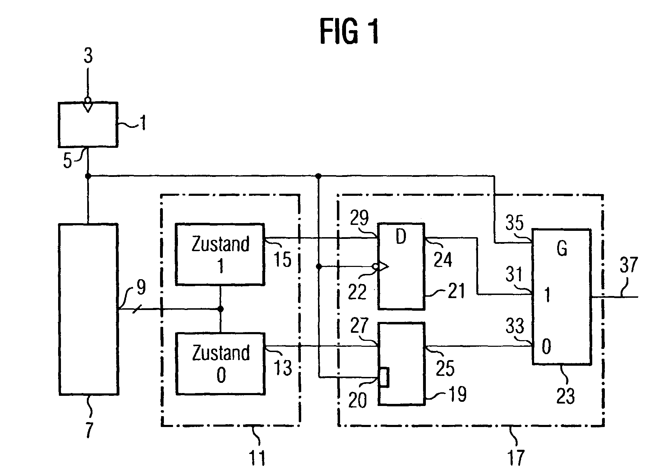

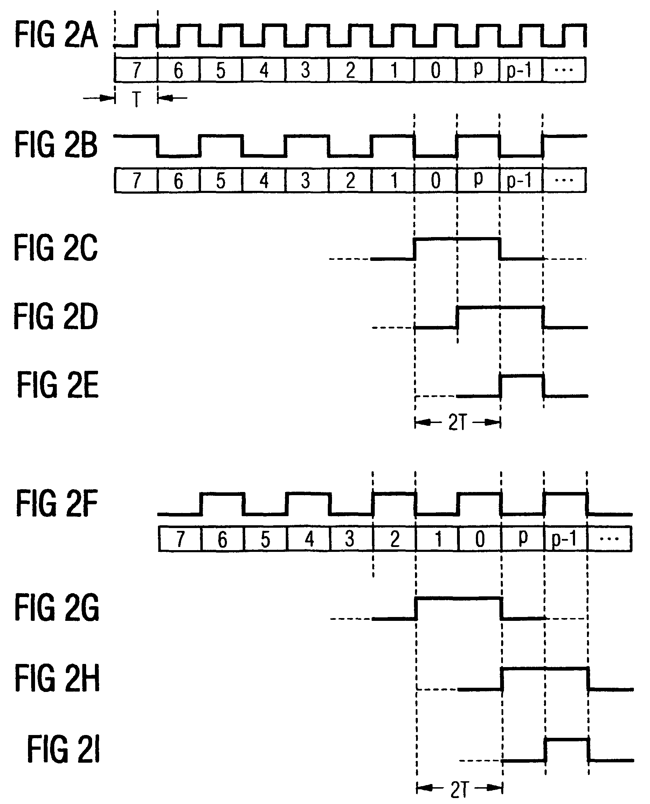

Wie in Fig. 1 darstellt, umfasst die Schaltungsanordnung einen Teiler 1, der den an seinem Eingang 3 anliegenden Takt mit der Periodendauer T (siehe Fig. 2a) auf das Verhältnis 1 zu 2 teilt, so dass der am Ausgang 5 anliegende geteilte Takt (siehe Fig. 2b und Fig. 2f) gegenüber dem am Eingang 3 anliegenden Takt in der Frequenz halbiert ist und die Periodendauer 2T besitzt.

Der Teiler 1 kann hier beispielsweise als taktflankengesteuertes T-Flip-Flop, insbesondere als negativtaktflankengesteuertes T-Flip-Flop, ausgebildet sein.

Dieser geteilte Takt (siehe Fig. 2b und Fig. 2f) wird von einer Zähleinheit 7, beispielsweise einem Zähler herkömmlicher Bauart, deren Eingang mit dem Ausgang 5 des Teilers 1 verbunden ist, mit der Schrittweite 2 gezählt.

Wie in Fig. 2b und Fig. 2f dargestellt, sind zwei Werte auf dem Zahlenstrahl einem Taktzyklus zugeordnet (erste und zweite Zyklushälfte), wobei ein Zyklus mit einer negativen Flanke beginnt und die Periodendauer 2T aufweist. Diese Zyklusart kann beispielsweise durch eine auf die negative Taktflanke getriggerte Zähleinheit 7 erreicht werden. Selbstverständlich ist auch eine andere Steuerung, wie eine positivflankengesteuerte HIHG- oder LOW-Pegelsteuerung denkbar.

Am Ausgang 9 der Zähleinheit 7 liegt das Ergebnis der Zählung eines jeweiligen Taktzyklus als Binärzahl vor, wobei diese über einen Datenbus mit der Breite m, beispielsweise 7 Bit, mit einer Analyseeinheit 11 verbunden ist.

Das Ergebnis wird in der nachgeschalteten Analyseeinheit 11 auf den Zustand 0 oder 1 überprüft, da sich der Zustand "0" nach der Taktteilung in der ersten (Fig. 2b) oder zweiten (Fig. 2f) Zyklushälfte befinden kann. Die Analyseeinheit 11 ist hierbei beispielsweise aus OR- und/oder NOR-Gattern aufgebaut.

Wird in dieser Analyseeinheit 11, welche mit dem Ausgang 9 der Zähleinheit 7 verbunden ist, der Zustand "0" am Anfang eines Zyklus detektiert, so wird am Ausgang 13 der Analyseeinheit 11 eine "1" bzw. "HIGH" für diesen Zyklus für die Dauer 2T ausgegeben (Fig. 2c). Wird dagegen am Ausgang 9 der Zustand "1" am Anfang eines Zyklus detektiert, so wird am Ausgang 15 der Analyseeinheit 11 eine "1" bzw. "HIGH" für diesen Zyklus für die Dauer 2T ausgegeben (Fig. 2g).

Die Ausgänge 13 und 15 sind mit den Eingängen 27, 29 einer Zuordnungseinheit 17 verbunden, die beispielsweise aus einem Latch 19, einem Master-Slave-Flip-Flop 21 mit D-Eingang und einem Multiplexer 23 aufgebaut ist.

Die Takteingänge 20, 22 des Latches 19 und des Flip-Flops 21 sind jeweils mit dem Ausgang 5 des Teilers 1 verbunden, so dass der geteilte Takt (Fig. 2b und Fig. 2f) an diesen Eingängen 20, 22 anliegt. Wie in Fig. 1 dargestellt, handelt es sich bei dem Flip-Flop 21 um ein negativtaktflankengesteuertes Master-Slave-Flip-Flop, welches bei einer ersten Negativflanke den am Eingang 29 anliegenden Zustand an seinen Ausgang 24 durchschaltet (Fig. 2h) und mit der nachfolgenden Negativflanke wieder zurückschaltet.

Am Ausgang 25 (Fig. 2d) des Latches 19 erfolgt dagegen erst bei Anliegen einer "1" bzw. eines HIGH-Pegels am Clock-Eingang 20 eine Zustandsänderung auf den am Eingang 27 anliegenden Zustand. Der Eingang 27 des Latches 19 ist hierbei mit dem Ausgang 13 der Analyseeinheit 11 verbunden und der D-Eingang 29 des Flip-Flops 21 mit dem Ausgang 15 der Analyseeinheit 11.

Der Ausgang 24 des Flip-Flops 21 ist mit einem "1"- bzw. "HIGH"-Eingang 31 des Multiplexers 23 und der Ausgang 25 des Latches 19 mit einem "0"- bzw. "LOW"-Eingang 33 des Multiplexers 23 verbunden. Der Takteingang 35 des Multiplexers 23 ist wiederum mit dem Ausgang 5 des Teilers 1 verbunden, so dass der geteilte Takt (Fig. 2b, Fig. 2f) auch hier anliegt.

Auf diese Weise wird, wie vorstehend beschrieben, eine am Eingang 29 des Flip-Flops 21 anliegende und an dessen Ausgang 24 durchgeschaltete "1" (also eine detektierte "1" am Taktzyklusanfang) erst bei einer "1" bzw. einem HIGH-Pegel des am Eingang 35 anliegenden geteilten Taktes an den Ausgang 37 (Fig. 2i) durchgeschaltet.

Eine, wie vorstehend beschrieben, am Eingang 27 des Latches 19 anliegende und an dessen Ausgang 25 durchgeschaltete "1" (also eine detektierte "0" am Taktzyklusanfang) wird dagegen bei einer "0" bzw. einem LOW-Pegel des am Eingang 35 anliegenden geteilten Taktes an den Ausgang 37 (Fig. 2e) durchgeschaltet.

Wie aus den Fig. 2b bis Fig. 2e und Fig. 2f bis Fig. 2i ersichtlich, erfolgt hierdurch am Ausgang 37 eine um Periodendauer 2T des geteilten Taktes zeitversetzte korrekte Zuordnung des Wertes "0" zu einem Impuls in Abhängigkeit der Zustände des geteilten Taktes - "0" am Taktzyklusanfang (also "0" in der ersten Bithälfte) oder "1" am Taktzyklusanfang (also "0" in der zweiten Bithälfte).

Der ausgegebene Impuls kann, wie im Ausführungsbeispiel dargestellt, vorteilhafterweise die Impulsbreite des "dekodierten" Impulses des geteilten Taktes aufweisen.

Diese Analyse und Zuordnung ist nötig, da sich, wie im Ausführungsbeispiel dargestellt, in einem Taktzyklus des geteilten Taktes zwei Werte, nämlich ein Wert 1 in der ersten Zyklushälfte und ein Wert n-1 in der zweite Hälfte, verbergen. Demzufolge kann sich die zu detektierende "0" oder ein anderer vordefinierter Endwert in der ersten oder zweiten Hälfte eines Taktzyklus befinden. Wie vorstehend beschrieben, wird dies nach der Erfindung anhand des Anfangszustandes des Zyklus des geteilten Taktes analysiert und in Abhängigkeit hiervon als Ergebnis die Lage der "0" im Zyklus festgestellt. Mittels der Zuordnungseinheit 17 wird dann in Abhängigkeit von diesem Ergebnis am Ausgang 37 der Wert "0" in seiner korrekten, um die Periodendauer 2T versetzten zeitlichen Position ausgegeben.

Hierbei ist anzumerken, dass eine derartige Zeitversetzung um eine Periodendauer ("Abtakten") bei herkömmlichen Dualzählern durchaus üblich ist, um Fehler wie races, spikes usw. zu vermeiden.

Das Ergebnis und eventuell zusätzlich die Zwischenschritte der Zähleinheit können in einer in der Zeichnung nicht dargestellten Ausgabeeinheit ausgegeben werden und/oder mittels einer Steuereinheit andere Vorgänge steuern.

Selbstverständlich ist dieses Verfahren bzw. die Schaltungsanordnung nicht auf das dargestellte Beispiel einer Frequenzhalbierung begrenzt, sondern kann durch geeignete Anpassung (n Zustände analysieren und zuordnen) auf eine n-fache Teilung des Taktes angewendet werden.

## Patentansprüche

1. Verfahren zum Hochgeschwindigkeitszählen von Taktzyklen eines Taktes,
- bei dem der Takt (Fig. 2a) in einem ersten Schritt in einem Verhältnis 1 zu n geteilt wird,
- die Zyklen des geteilten Taktes (Fig. 2b, Fig. 2f) von einer Zähleinheit (7) gezählt werden, wobei diese Zähleinheit (7) pro Taktzyklus n Schritte zählt,
- die Taktzyklen des geteilten Taktes (Fig. 2b, Fig. 2f) hinsichtlich eines Wertes 0 bis n-1 analysiert werden und
- bei einem Auftreten eines Wertes 0 bis n-1 in dessen Abhängigkeit eine Verzögerung eines Signals (Fig. 2e, Fig. 2i) erzeugt und ausgegeben wird.

2. Verfahren nach Anspruch 1, **dadurch gekennzeichnet,** dass der Takt (Fig. 2a) in einem ersten Schritt in einem Verhältnis 1 zu 2 (Fig. 2b, Fig. 2f) geteilt wird.

3. Verfahren nach Anspruch 1 oder 2, **dadurch gekennzeichnet,** dass, ausgehend von einem ersten vordefinierten Wert x bis zu einem zweiten vordefinierten Wert y, abwärts oder aufwärts gezählt wird.

4. Verfahren nach Anspruch 3, **dadurch gekennzeichnet,** dass der erste und/oder der zweite vordefinierte Wert vor dem Zählen geladen werden kann.

5. Verfahren nach Anspruch 3 oder 4, **dadurch gekennzeichnet,** dass der erste oder der zweite vordefinierte Wert 0 ist.

6. Schaltungsanordnung zur Durchführung des Verfahrens nach einem der Ansprüche 1 bis 5, mit einer Zähleinheit (7), **dadurch gekennzeichnet,** dass
- der Zähleinheit (7) ein Teiler (1) vorgeschaltet ist, um einen Takt (Fig. 2a) in einem Verhältnis 1 zu n zu teilen,
- die Zähleinheit (7) als n-Schritt-Zähler ausgebildet ist,
- die Schaltungsanordnung eine Analyse- (11) und Zuordnungseinheit (17) aufweist, um die Zyklen des geteilten Taktes (Fig. 2b, Fig. 2g) hinsichtlich eines Wertes 0 bis n-1 zu analysieren und bei einem Auftreten eines Wertes 0 bis n-1 in dessen Abhängigkeit eine Verzögerung eines Signals (Fig. 2e, Fig. 2i) zu erzeugen und auszugeben.

7. Schaltungsanordnung nach Anspruch 6, **dadurch gekennzeichnet,** dass der Teiler (1) als 1 zu 2 Teiler ausgebildet ist.

8. Schaltungsanordnung nach Anspruch 7, **dadurch gekennzeichnet,** dass die Zähleinheit (7) als Dualzähler ausgebildet ist, der mit einem ersten und/oder zweiten vordefinierten Wert ladbar ist, um von einem ersten bis zu einem zweiten Wert zu zählen.

9. Schaltungsanordnung nach Anspruch 8, **dadurch gekennzeichnet,** dass die Zähleinheit (7) als Abwärtszähler ausgebildet ist.

10. Schaltungsanordnung nach Anspruch 9, **dadurch gekennzeichnet,** dass der zweite vordefinierte Wert 0 ist.
